# EUROPEAN PATENT APPLICATION

(11) **EP 4 814 964 A1**
(43) Date of publication of application: **30.09.2026**
(21) Application number: 26166111.0
(22) Date of filing: 19.03.2026
(51) Int. Cl.: G11C 11/16, G11C 13/00

(54) **MEMORY SYSTEM**

(30) Priority: 28.03.2025 JP 2025055154
(71) Applicant: AISIN CORPORATION, Kariya, Aichi 448-8650 (JP)
(72) Inventor: NARUSE, Takanobu, KARIYA, AICHI, 448-8650 (JP)
(74) Representative: Cabinet Beau de Loménie

(57) **Abstract**

A memory system according to an embodiment includes: an STT-MRAM having a plurality of memory areas for storing data; and a memory controller configured to control a write (W1, W2), a read (R1, R2), and a refresh (RF1, RF2) for each of the plurality of memory areas, wherein the memory controller performs a refresh on a predetermined one of the memory areas in a case where a predetermined time (T1, T2) has elapsed since a last write.

## Description

### TECHNICAL FIELD

An embodiment of the present disclosure relates to a memory system.

### BACKGROUND DISCUSSION

In recent years, spin transfer torque-magnetoresistive random access memory (STT-MRAM) has been researched and developed. The STT-MRAM is a memory (storage device) using a magnetoresistance effect, and has excellent features such as high-speed write (writing operation)/read (reading operation) and non-volatility as compared with conventional dynamic random access memory (DRAM), static random access memory (SRAM), and the like. As a next-generation memory, application in many fields such as smartphones, personal computers, and vehicles (such as automobiles) is promising.

The STT-MRAM typically has about one trillion rewrite cycles, and has a short data holding time (period in which data can be held) of about several seconds to several tens of seconds. Thus, in order to hold data, it is necessary to perform a refresh (refreshing operation) before the data is lost. Therefore, for example, a method is considered in which, in a situation where it is necessary to hold data, a refresh is simply performed every certain period shorter than the data holding time (see JP 2016-115354 A).

However, in the above-described method, an unnecessary refresh may be sometimes performed. For example, while writes are sequentially performed at time intervals shorter than the data holding time, it is unnecessary to perform a refresh, but the refresh is performed. Performing an unnecessary refresh leads to an increase in power consumption and a decrease in access performance due to an inability to access a memory during a refresh.

A need thus exists for a memory system that can reduce an unnecessary refresh with respect to an STT-MRAM.

### SUMMARY

A memory system according to an embodiment includes: an STT-MRAM having a plurality of memory areas for storing data; and a memory controller configured to control a write, a read, and a refresh for each of the plurality of memory areas, wherein the memory controller performs a refresh on a predetermined one of the memory areas in a case where a predetermined time has elapsed since a last write.

According to this configuration, an unnecessary refresh can be reduced with respect to the STT-MRAM.

### BRIEF DESCRIPTION OF THE DRAWINGS

The foregoing and additional features and characteristics of this disclosure will become more apparent from the following detailed description considered with the reference to the accompanying drawings, wherein:
Fig. 1 is a functional configuration diagram of an ECU according to an embodiment;
Fig. 2 is a diagram illustrating an execution example of a write, a read, and a refresh for an MRAM over time; and
Fig. 3 is a flowchart illustrating processing related to a refresh of the MRAM.

### DETAILED DESCRIPTION

Hereinafter, an exemplary embodiment of the present disclosure will be disclosed. A configuration of the embodiment described below, and actions, results, and effects brought by the configuration are examples. The present disclosure can be realized by a configuration other than that disclosed in the following embodiment, and at least one of various effects based on a basic configuration and derivative effects can be obtained. In the following embodiment, a case where a memory system of the present disclosure is applied to an electronic control unit (ECU) used in a vehicle (such as an automobile) or the like will be described as an example.

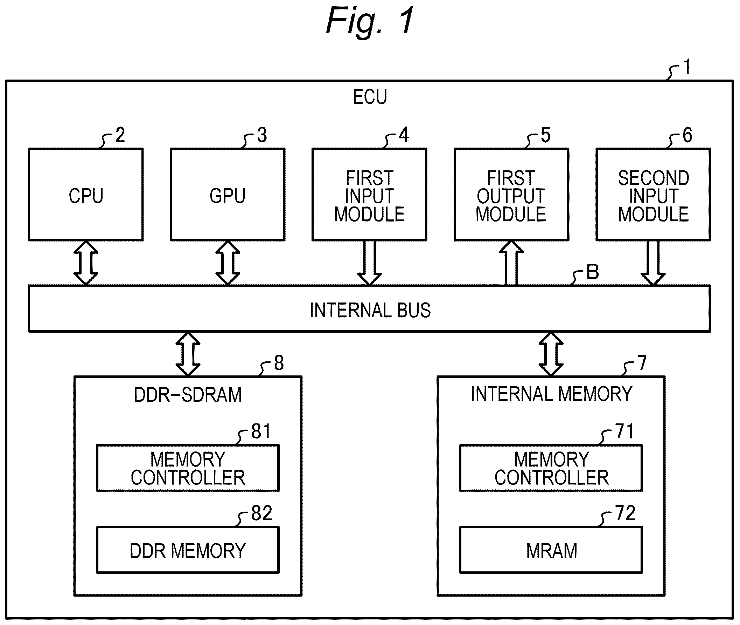

Fig. 1 is a functional configuration diagram of an ECU 1 according to an embodiment. In the ECU 1, a central processing unit (CPU) 2, a graphics processing unit (GPU) 3, a first input module 4, a first output module 5, a second input module 6, an internal memory 7 (memory system), and a double data rate-synchronous dynamic random access memory (DDR-SDRAM) 8 are disposed so as to be able to communicate with each other via an internal bus B. Note that this drawing is illustrated in a simplified manner, and in reality, for example, a direct memory access (DMA) controller, a cache memory, and the like may be provided as an additional configuration.

The CPU 2 executes various arithmetic processing. For example, the CPU 2 transmits an instruction signal to the first input module 4 or the second input module 6 to store input data in the internal memory 7 or the DDR-SDRAM 8.

The GPU 3 mainly executes image processing.

The first input module 4 transmits input predetermined data to the internal memory 7 or the DDR-SDRAM 8 via the internal bus B. The first input module 4 is, for example, a video input module.

The first output module 5 outputs predetermined data received from the internal memory 7 or the DDR-SDRAM 8 via the internal bus B. The first output module 5 is, for example, a display output module. In this case, for example, the GPU 3 transmits an instruction signal to the first output module 5 to cause a display device (not illustrated) to display the information received from the data internal memory 7 or the DDR-SDRAM 8.

Similarly to the first input module 4, the second input module 6 transmits input predetermined data to the internal memory 7 or the DDR-SDRAM 8 via the internal bus B.

The internal memory 7 is a storage device, and includes a memory controller 71 and an MRAM 72 (STT-MRAM).

The MRAM 72 has a plurality of memory areas for storing data.

The memory controller 71 controls a write, a read, a refresh, and the like for each of the plurality of memory areas of the MRAM 72. For example, the memory controller 71 performs a refresh on a predetermined memory area in a case where a predetermined time has elapsed since a last write.

A target memory area to be refreshed is set among the plurality of memory areas in the MRAM 72. The memory controller 71 performs a refresh on the target memory area in a case where the predetermined time has elapsed since the last write.

A first write and a second write having a longer write time than the first write are also set as the write. A first predetermined time as the predetermined time is set for the first write, and a second predetermined time longer than the first predetermined time as the predetermined time is set for the second write. The MRAM 72 typically has a property that the longer the write time, the longer the data holding period. This is because the degree of alignment of a plurality of magnetic spins in the MRAM 72 becomes stronger (that is, the stability of a magnetization state is enhanced) as the write time becomes longer.

The memory controller 71 performs a refresh on a target memory area to be subjected to the first write in a case where the first predetermined time has elapsed since the last first write.

The memory controller 71 also performs a refresh on a target memory area to be subjected to the second write in a case where the second predetermined time has elapsed since the last second write.

The DDR-SDRAM 8 includes a memory controller 81 and a DDR memory 82. In the present embodiment, the DDR-SDRAM 8 refers to the following.
(1) Low-power (LP) DDR4-SDRAM, LPDDR4x-SDRAM, LPDDR5-SDRAM, LPDDR5x-SDRAM, or the like (for example, applied to a smartphone or a vehicle)
(2) Graphics (G) DDR5-SDRAM, GDDR5x-SDRAM, GDDR6-SDRAM, GDDR7-SDRAM, or the like (for example, applied to a graphic board)
(3) DDR4-SDRAM, DDR5-SDRAM, DDR6-SDRAM, or the like (for example, applied to a personal computer)

The DDR memory 82 has a plurality of memory areas for storing data.

The memory controller 81 controls a write, a read, a refresh, and the like for each of the plurality of memory areas of the DDR memory 82.

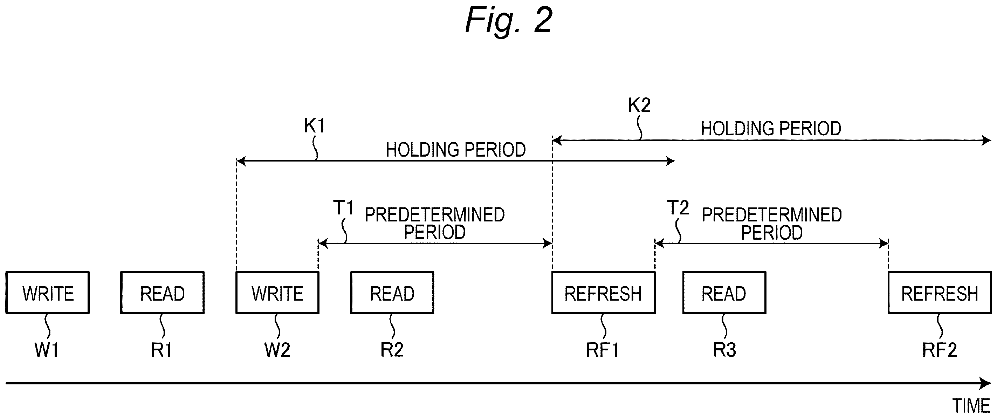

Fig. 2 is a diagram illustrating an execution example of a write, a read, and a refresh for the MRAM 72 over time. First, in a case where a write W1, a read R1, a write W2, and a read R2 are performed, data written in the write W2 is held during a holding period K1. Therefore, in a case where a predetermined period T1 set to be shorter than the holding period K1 by a predetermined time length has elapsed in a state where there is no new write from the write W2 (last write), a refresh RF1 is performed.

As a result, data written in the refresh RF1 is held during a holding period K2 (= holding period K1). Therefore, in a case where a predetermined period T2 (= predetermined period T1) set to be shorter than the holding period K2 by a predetermined time length has elapsed in a state where there is no new write from the refresh RF1 (last write) (in a state where there is a read R3 but there is no new write), a refresh RF2 is performed.

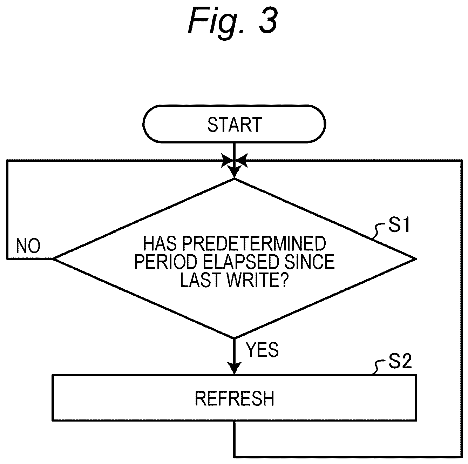

Fig. 3 is a flowchart illustrating processing related to a refresh of the MRAM 72. In step S1, the memory controller 71 determines whether or not the predetermined time has elapsed since the last write with respect to the target memory area of the MRAM 72. In the case of Yes, the process proceeds to step S2, and in the case of No, the process returns to step S1.

In step S2, the memory controller 71 performs a refresh on the target memory area of the MRAM 72.

As described above, according to the internal memory 7 (memory system) of the ECU 1 of the present embodiment, a refresh is performed on the predetermined memory area of the MRAM 72 in a case where the predetermined time has elapsed since the last write. This makes it possible to reduce an unnecessary refresh with respect to the MRAM 72, and thus makes it possible to suppress an increase in power consumption and a decrease in access performance due to an inability to access the memory during a refresh.

A refresh is also performed only on the memory area set as a target to be refreshed among the plurality of memory areas of the MRAM 72 in a case where the predetermined time has elapsed since the last write. As a result, no refresh is performed at all on a memory area that is not set as a target to be refreshed, which makes it possible to further reduce an unnecessary refresh.

The first write and the second write having different required times are set as the write, and the predetermined times having different lengths are set for the respective writes. This makes it possible to perform a refresh on each of the first write and the second write after the elapse of an appropriate time since the last write.

Next, an application example of the present disclosure will be described. The internal memory 7 of the present disclosure can be used, for example, as a frame buffer in image processing of a moving image. In this case, since a write associated with frame update frequently occurs during normal operation, a refresh for data retention is unnecessary.

On the other hand, in a special operation mode (for example, when a drive recorder of a vehicle stores a video at the occurrence of a vehicle accident), it is necessary to hold the content of the frame buffer. In this case, it is necessary to perform a refresh frequently and consecutively, and it is necessary to consider measures against an increase in power consumption and a decrease in access performance due to an inability to access the memory during a refresh at the time of system design.

According to the internal memory 7 of the present disclosure, an unnecessary refresh can be reduced, which makes it possible to suppress the increase in power consumption and the decrease in access performance due to an inability to access the memory during a refresh.

By making it possible to switch ON/OFF a refresh function using a setting register, an external pin, or the like, a refresh is stopped when the internal memory 7 is not used, so that a further reduction in power consumption can be achieved.

Note that the program executed by the ECU 1 may be provided as a computer program product by being stored as a file in an installable format or an executable format in a computer-readable storage medium such as a CD-ROM, a CD-R, a memory card, a digital versatile disk (DVD), or a flexible disk (FD). Moreover, the program may be provided by being stored on a computer connected to a network such as the Internet and downloaded via the network. Furthermore, the program may be provided or distributed via a network such as the Internet.

Although the embodiment of the present disclosure has been described above, the above embodiment has been presented as an example, and is not intended to limit the scope of the disclosure. This novel embodiment can be implemented in various other forms, and various omissions, substitutions, and changes can be made without departing from the gist of the disclosure. This embodiment and modifications thereof are included in the scope and gist of the disclosure and are included in the disclosure described in the claims and the scope of equivalents thereof.

For example, an application destination of the memory system of the present disclosure is not limited to the ECU used in a vehicle or the like of the above-described embodiment, and may be another field such as a smartphone or a personal computer.

In the above-described embodiment, the first write and the second write having different required times are set as the write, and the predetermined times having different lengths are set for the respective writes. However, the write is not limited thereto. For example, three types of writes (a high-speed write, a medium-speed write, a low-speed write) having different required times may be set as the write, and predetermined times having different lengths may be set for the respective writes. Similarly, four or more types of writes having different required times and predetermined times having different lengths for the respective writes may be set.

### Summary of Present Embodiment

The present embodiment includes at least the following configuration.

A memory system according to an embodiment includes: an STT-MRAM having a plurality of memory areas for storing data; and a memory controller configured to control a write, a read, and a refresh for each of the plurality of memory areas, wherein the memory controller performs a refresh on a predetermined one of the memory areas in a case where a predetermined time has elapsed since a last write.

With such a configuration, an unnecessary refresh can be reduced with respect to the STT-MRAM, which makes it possible to suppress an increase in power consumption and a decrease in access performance due to an inability to access the memory during a refresh.

A target memory area to be refreshed is set among the plurality of memory areas, and the memory controller performs a refresh on the target memory area in a case where the predetermined time has elapsed since the last write.

With such a configuration, no refresh is performed at all on a memory area that is not set as a target to be refreshed, which makes it possible to further reduce an unnecessary refresh.

A first write and a second write having a longer write time than the first write are set as the write, a first predetermined time as the predetermined time is set for the first write, and a second predetermined time longer than the first predetermined time as the predetermined time is set for the second write.

With such a configuration, it is possible to perform a refresh on each of the first write and the second write after the elapse of an appropriate time since the last write.

Note that the effects of the dependent claims and the embodiment are additional effects different from the effects of the independent claim.

## Claims

1. A memory system (7) comprising:
a spin transfer torque-magnetoresistive random access memory (STT-MRAM) (72) having a plurality of memory areas for storing data; and
a memory controller (71) configured to control a write, a read, and a refresh for each of the plurality of memory areas, wherein
the memory controller (71) performs a refresh on a predetermined one of the memory areas in a case where a predetermined time has elapsed since a last write.

2. The memory system (7) according to Claim 1, wherein
a target memory area to be refreshed is set among the plurality of memory areas, and
the memory controller (71) performs a refresh on the target memory area in a case where the predetermined time has elapsed since the last write.

3. The memory system (7) according to Claim 1 or 2, wherein
a first write and a second write having a longer write time than the first write are set as the write,
a first predetermined time as the predetermined time is set for the first write, and
a second predetermined time longer than the first predetermined time as the predetermined time is set for the second write.
